# EUROPEAN PATENT APPLICATION

(11) **EP 0 538 807 A1**
(43) Date of publication of application: **28.04.1993**
(21) Application number: 92117949.5
(22) Date of filing: 20.10.1992
(51) Int. Cl.: H01L 27/06, H01L 21/3205

(54) **Semiconductor integrated circuit device having additional capacitor effectively decreasing parasitic capacitance coupled with resistor**

(30) Priority: 25.10.1991 JP 279416/91
(71) Applicant: NEC CORPORATION, Tokyo (JP)
(72) Inventor: Shimizu, Junzoh, Minato-ku, Tokyo (JP)
(74) Representative: Glawe, Delfs, Moll & Partner

(57) **Abstract**

A semiconductor integrated circuit device is fabricated on a semiconductor substrate (11) having a lightly doped p-type silicon bulk (11a) and a lightly doped n-type epitaxial layer (11b), and a resistor is formed on a field oxide film (12) grown on the lightly doped n-type epitaxial layer, wherein a trench isolation (13a/ 13b/ 14a/ 14b) penetrates from the field oxide film into the lightly doped p-type silicon bulk for allowing a part (11c) of the lightly doped epitaxial layer under the resistor to enter electrically isolating state, thereby decreasing parasitic capacitance coupled with the resistor by virtue of an additional junction capacitor coupled in series therewith.

## Description

### FIELD OF THE INVENTION

This invention relates to a semiconductor integrated circuit device and, more particularly, to a resistor incorporated in the semiconductor integrated circuit device.

### DESCRIPTION OF THE RELATED ART

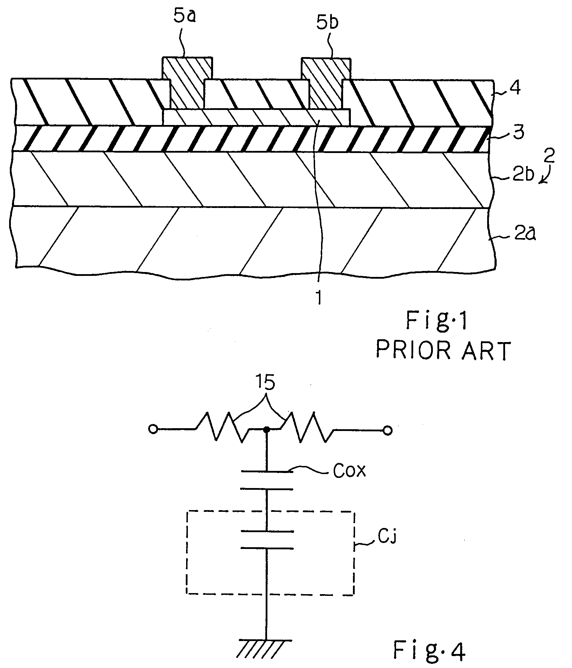

Referring first to Fig. 1 of the drawings, a resistor element forming a part of a semiconductor integrated circuit device such as an emitter coupled logic circuit is implemented by a polysilicon strip 1. The semiconductor integrated circuit device is fabricated on a silicon substrate 2, and the silicon substrate 2 comprises a lightly doped p-type silicon film 2a, and a lightly doped n-type silicon film 2b epitaxially grown on the p-type silicon film 2a. A thick silicon oxide film 3 is grown on the lightly doped n-type silicon film 2b to thickness of 300 nanometers to 1 micron, and the polysilicon strip 1 is formed on the thick silicon oxide film 3. Namely, after growth of the thick silicon oxide film 3, a polysilicon film is deposited over the thick silicon oxide film 3, and is patterned into the polysilicon strip 1. The geometry of the polysilicon strip 1 is appropriate for predetermined resistance. If the polysilicon strip 1 is expected to provide large resistance, a large amount of heat takes place, and is radiated through the thick silicon oxide film 3 and the silicon substrate 2. If the silicon oxide film 3 is too thick to transmit the heat, accumulated heat decreases the resistivity of the polysilicon, and the polysilicon strip 1 hardly provides the predetermined resistance. For this reason, the thick silicon oxide film beneath the polysilicon strip 1 may be decreased to 100 nanometers thick.

Silicon oxide is deposited over the entire surface, and the polysilicon strip 1 is covered with a silicon oxide film 4. Contact holes are formed in the silicon oxide film 4, and reach the upper surface of the polysilicon strip 1. Electrodes 5a and 5b respectively pass through the contact holes, and are held in contact with the upper surface of the polysilicon strip 1.

Integrated circuits are expected to accelerate switching actions, and the circuit components are progressively miniaturized for high speed switching actions. The scaling-down of the circuit components affects the film thicknesses of the structure, and does not make an exception in the thick silicon oxide film 3. Moreover, if bipolar transistors are integrated with CMOS transistors for a Bi-CMOS configuration, the bipolar process is modified so as to be matched with the CMOS process, and the modification tends to decrease the thickness of the thick silicon oxide film 3. For example, if a Bi-CMOS circuit is designed under 0.5-micron design rules, the thick silicon oxide film 3 is as thin as 300 nanometers which is a half of that designed under 1-micron rules.

Thus, the thick silicon oxide film 3 tends to be decreased in thickness, and this tendency is desirable in view of heat radiation. Of course, when a resistor is scaled down, the amount of heat radiated therefrom is decreased, and the scaled-down silicon oxide film 3 is not so drastically effective. However, the polysilicon strip 1 forms a parasitic capacitor together with the thick silicon oxide film 3 and the lightly doped n-type silicon film 2b, and the parasitic capacitor introduces time delay into propagation of a signal passing through the polysilicon strip 1. The thinner the silicon oxide film 3, the larger the parasitic capacitance. Therefore, the tendency is not desirable in view of high-speed signal propagation.

### SUMMARY OF THE INVENTION

It is therefore an important object of the present invention to provide a semiconductor integrated circuit device a resistor of which effectively decreases parasitic capacitance.

To accomplish the object, the present invention proposes to form an additional capacitor coupled between a parasitic capacitor and a substrate.

In accordance with the present invention, there is provided a semiconductor integrated circuit device comprising a) a semiconductor substrate having a first semiconductor layer of a first conductivity type, and a second semiconductor layer grown on the first semiconductor layer and having a second conductivity type opposite to the first conductivity type, the first and second semiconductor layers being reversely biased with each other, b) an insulating film formed over the second semiconductor layer, c) a plurality of circuit components having a resistor formed on the insulating film, and d) an electrically isolating means projecting from the insulating film into the first semiconductor layer for allowing a part of the second semiconductor layer under the insulating film to enter electrically floating state.

### BRIEF DESCRIPTION OF THE DRAWINGS

The features and advantages of the semiconductor integrated circuit device according to the present invention will be more clearly understood from the following description taken in conjunction with the accompanying drawings in which:
Fig. 1 is a cross sectional view showing the structure of the prior art semiconductor integrated circuit device;
Fig. 2 is a circuit diagram showing an electric circuit to which the present invention is appertains;
Fig. 3 is a cross sectional view showing the structure of a resistor according to the present invention;
Fig. 4 is a circuit diagram showing an equivalent circuit around the resistor;
Fig. 5 is a cross sectional view showing the structure of another resistor according to the present invention;
Fig. 6 is a cross sectional view showing the structure of yet another resistor according to the present invention; and
Fig. 7 is a cross sectional view showing the structure of still another resistor according to the present invention.

### DESCRIPTION OF THE PREFERRED EMBODIMENTS

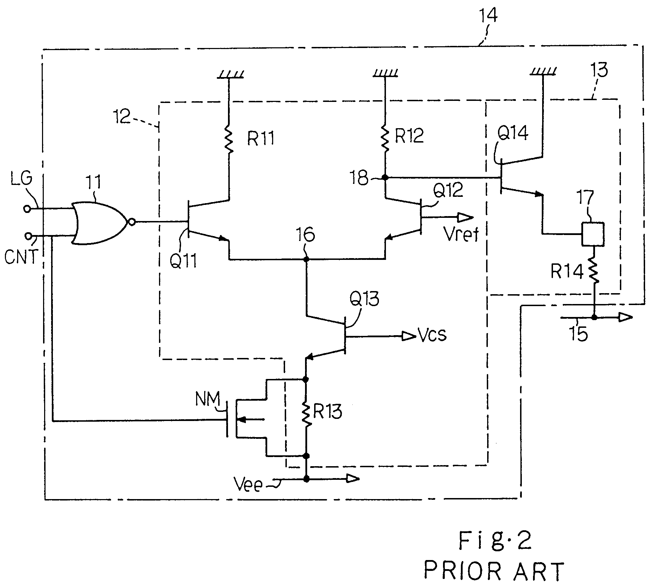

Referring to Fig. 2 of the drawings, a three state emitter coupled logic circuit to which the present invention appertains largely comprises a logic circuit implemented by a NOR gate 11, a differential amplifier circuit 12, an output circuit 13 and a bypassing circuit implemented by an n-channel enhancement type field effect transistor NM. The three state emitter coupled logic circuit is fabricated on a semiconductor chip 14, and is coupled with a terminating voltage line 15. The terminating voltage line 15 is coupled with an end voltage level source or a negative low voltage level. However, the terminating voltage line 15 may be provided on the semiconductor chip where the emitter coupled logic circuit is fabricated.

The differential amplifier circuit 12 has a first series combination of a first resistor R11 and a first n-p-n bipolar transistor Q11 coupled between a ground node and a common node 16, a second series combination of a second resistor R12 and a second n-p-n bipolar transistor Q12 coupled between the ground node and the common node 16 in parallel to the first series combination, and a third series combination of a third n-p-n bipolar transistor Q13 and a third resistor R13 coupled between the common node and a negative constant voltage source Vee. The first n-p-n bipolar transistor Q11 is supplied at the base node thereof with an internal logic signal fed from the NOR gate 11, and a reference voltage level Vref is supplied to the base node of the second n-p-n bipolar transistor Q12. The reference voltage level Vref is selected in such a manner that the first and second n-p-n bipolar transistors Q11 and Q12 complementarily turn on and off depending upon the voltage level of the internal logic signal.

The output circuit 13 is formed by a series combination of a fourth n-p-n bipolar transistor Q14, an output node 17 and a fourth resistor R14, and the fourth n-p-n bipolar transistor Q14 is coupled at the base node thereof with an intermediate node 18 between the second resistor R12 and the second n-p-n bipolar transistor Q12. The bypassing circuit or the n-channel enhancement type filed effect transistor NM is coupled in parallel with the third resistor R13, and the n-channel enhancement type field effect transistor NM is supplied at the gate electrode thereof with the three state control signal CNT. The bypassing circuit thus coupled is responsive to the three state control signal CNT, and provides a current path between the third n-p-n bipolar transistor Q13 and the negative constant voltage source Vee. The fourth n-p-n bipolar transistor Q14 selectively increases or decreases the collector current thereof depending upon the voltage level at the intermediate node 18 in a logic function mode of operation, however, the fourth n-p-n bipolar transistor Q14 is surely maintained in the off state with an extremely low voltage level at the intermediate node 18. Namely, if the intermediate node 18 is shifted between the ground voltage level (or high voltage level) and negative voltage level (or low voltage level) depending upon the state of the second n-p-n bipolar transistor Q12, the three state emitter coupled logic circuit enters the logic function mode, and, accordingly, the fourth n-p-n bipolar transistor Q14 increases or decreases the collector current thereof for providing an output signal of either high or low voltage level at the output node 17. In this instance, the collector current of the fourth n-p-n bipolar transistor Q14 is varied between about 20 milli-ampere and about 5 milli-ampere, and, accordingly, the output signal swings the voltage level thereof between about -0.9 volt and about -1.7 volt. However, if the n-channel enhancement type field effect transistor NM turns on to provide the current path, the intermediate node 18 is decreased in voltage level toward the extremely low voltage level due to a large amount of current increased, and the fourth n-p-n bipolar transistor Q14 can not turn on. This means that the high impedance state is established in the three state emitter coupled logic circuit. For maintaining the fourth n-p-n bipolar transistor in the off state, it is necessary that the extremely low voltage level is lower than the total sum of the end voltage level and the forwardly biassed base emitter voltage level of the fourth n-p-n bipolar transistor Q14, and this is achieved by selecting the transistor size or the gate width of the n-channel enhancement type field effect transistor NM.

In operation, if the three stare control signal CNT goes down to inactive low voltage level, the NOR gate 11 produces the internal logic signal opposite in voltage level to the input logic signal. Moreover, the n-channel enhancement type field effect transistor NM remains in the off state with the three state control signal of the inactive low voltage level. In this situation, when the input logic signal goes up to the high voltage level, the internal logic signal of the low voltage level allows the first n-p-n bipolar transistor Q11 to turn off, which increases the differential voltage between the base and emitter nodes of the second n-p-n bipolar transistor Q12. The differential voltage thus increased allows the second n-p-n bipolar transistor Q12 to turn on so that the low voltage level appears at the intermediate node 18. With the low voltage level, the fourth n-p-n bipolar transistor Q14 decreases the collector current thereof, and, accordingly, the output signal is shifted to the negative low voltage level of about -0.9 volt. However, if the input logic signal LG is recovered to the low voltage level, the internal logic signal of the high voltage level allows the first n-p-n bipolar transistor Q11 to turn on, and the second n-p-n bipolar transistor Q12 turns off due to decrement in voltage level between the base and emitter nodes of the second n-p-n bipolar transistor Q12. This results in that the intermediate node 18 is increased in voltage level, and, accordingly, the forth n-p-n bipolar transistor Q14 increases the collector current thereof. As a result, the output signal at the node 17 is shifted to the high voltage level of about -1.7 volt. Thus, the three state emitter coupled logic circuit carries out the logical function in the presence of the three state control signal CNT of the inactive low voltage level, and the logical function is the inverting operation.

If, on the other hand, the three state control signal goes down to the active high voltage level, the NOR gate never respond to the input logic signal LG, and the internal logic signal remains in the low voltage level. This results in that the first n-p-n bipolar transistor Q11 is maintained in the off state. On the other hand, the n-channel enhancement type field effect transistor NM turns on to provide the additional current path, and, for this reason, the amount of the current passing through the third n-p-n bipolar transistor Q13 is increased. The first n-p-n bipolar transistor Q11 in the off state causes the second n-p-n bipolar transistor Q12 to turn on, and the current increased by the n-channel enhancement type field effect transistor NM decreases the voltage level at the intermediate node 18 due to the second resistor R12. When the intermediate node 18 reaches the extremely low voltage level, the fourth n-p-n bipolar transistor Q14 does not turn on, and the high impedance state is established in the three state emitter coupled logic circuit.

Thus, the resistors R11, R12, R13 and R14 are indispensable for the emitter coupled logic circuit together with the bipolar transistors Q11 to Q14 and the field effect transistor NM, and description is made on the structure of each of the resistor R11 to R14 according to the present invention.

### First Embodiment

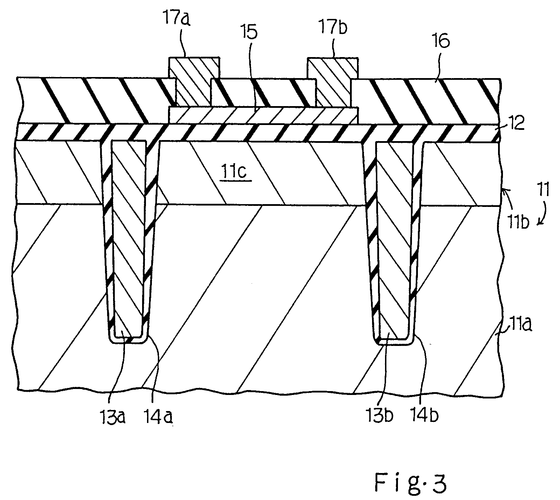

Referring to Fig. 3 of the drawings, a resistor embodying the present invention is fabricated on a silicon substrate 11, and the silicon substrate 11 has a lightly doped p-type silicon film 11a and a lightly doped n-type silicon film 11b epitaxially grown on the lightly doped p-type silicon film 11a. The lightly doped p-type silicon film 11a is reversely biased with each other, and a depletion layer extends from the p-n junction therebetween. The lightly doped n-type silicon film 11b is thermally oxidized so that a field oxide film 12 is selectively grown on the lightly doped n-type silicon film 11b. Trenches project from the field oxide film 12 into the lightly doped p-type silicon film 11a, and polysilicon blocks 13a and 13b wrapped with silicon oxide films 14a and 14b make up the trenches, respectively, thereby providing trench isolation for bipolar transistors. Though not shown in Fig. 3, n-tubs serving as collectors are defined by the silicon oxide films 14a and 14b, and the bipolar transistors are formed in the n-tubs, respectively. The polysilicon blocks 13a and 13b may be replaced with silicon oxide blocks, respectively.

The resistor is implemented by a polysilicon strip 15 on the field oxide film 12, and is located over a lightly doped n-type silicon region between the silicon oxide films 14a and 14b. The polysilicon strip 15 is covered with a silicon oxide film 16, and two contact holes are formed in the silicon oxide film 16. The two contact holes reach both side portions of the polysilicon strip 15, and electrodes 17a and 17b are respectively held in contact with both sides of the polysilicon strip 15 through the contact holes.

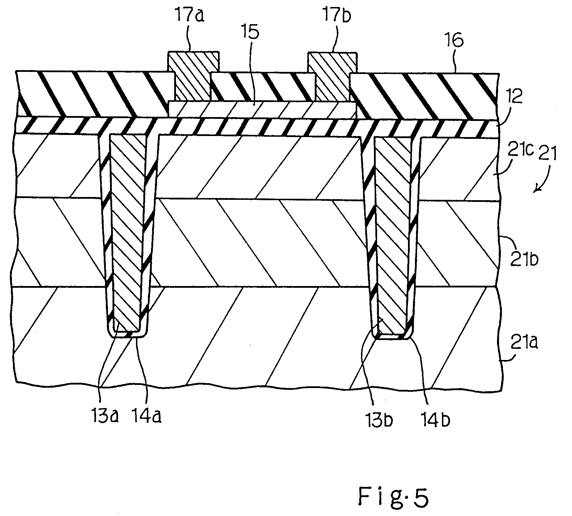

Since the trenches penetrate into the lightly doped p-type silicon film 11a, the lightly doped n-type silicon region 11c between the silicon oxide films 14a and 14b is electrically isolated from the remaining portion of the lightly doped n-type silicon film 11b, and electrically floating state is established in the lightly doped n-type silicon region 11c. In this situation, the lightly doped p-type silicon film 11a, the depletion layer and the lightly doped n-type silicon film 11b form in combination an additional capacitor Cj serially coupled with a parasitic capacitor Cox coupled with the resistor as shown in Fig. 4. In this instance, the lightly doped p-type silicon film 11a and the lightly doped n-type silicon film 11b have respective p-type dopant concentration of 1 x 10¹⁵ cm⁻³ and n-type dopant concentration of 5 x 10¹⁵ cm⁻³, and 3 to 5 volts are applied between the lightly doped p-type silicon film 11a and the lightly doped n-type silicon film 11b. The field oxide film 12 is 200 to 600 nanometers in thickness, and the p-n junction between the lightly doped n-type region 11a and the lightly doped p-type silicon film 11a is as wide as 10 to 100 square-microns. As a result, the additional capacitor Cj is approximately equal in capacitance to the parasitic capacitor Cox, and the actual capacitance coupled with the resistor is decreased to a half of the capacitance of the parasitic capacitor Cox. In fact, when an input signal was applied to an emitter coupled logic gate with the prior art resistor, time delay of 50 picosecond was introduced into the switching action. However, if the additional capacitor Cj according to the present invention decreases the actual parasitic capacitance to a half of that of the parasitic capacitor Cox, the switching action was accelerated at more than 10 %. Therefore, the additional capacitor Cj is effective against the time delay.

### Second Embodiment

Turning to Fig. 5 of the drawings, another structure of a resistor embodying the present invention is formed on a field oxide film 12 grown on a silicon substrate 21. The silicon substrate 21 comprises a lightly doped p-type silicon layer 21a, a heavily doped n-type buried layer 21b formed on the lightly doped p-type silicon layer 21a and a lightly doped n-type silicon layer 21c epitaxially grown on the buried layer 21b. The heavily doped n-type buried layer 21b is doped at 2 to 5 x 10¹⁹ cm⁻³. In this instance, the lightly doped p-type silicon layer 21a serves as a first semiconductor layer, and the heavily doped n-type silicon layer 21b and the lightly doped n-type silicon layer 21c as a whole constitute a second semiconductor layer. Therefore, polysilicon blocks 13a and 13b wrapped with silicon oxide films 14a and 14b penetrates into the lightly doped p-type silicon layer 21a for providing trench isolation. However, the other films and electrodes are similar to those of the first embodiment, and are labeled with the same references designating the corresponding films and electrodes without detailed description.

The trench isolation allows a part of the heavily doped n-type buried layer 21b and a part of the lightly doped n-type silicon layer 21c to enter electrically floating state, and the lightly doped p-type silicon layer 21a, a depletion layer at the p-n junction and the part of the heavily doped n-type buried layer 21b form in combination an additional capacitor coupled in series with a parasitic capacitor. The additional capacitor of the second embodiment is roughly equal in capacitance with the parasitic capacitor, and the actual capacitance coupled with the resistor is decreased to a half as similar to the first embodiment.

### Third Embodiment

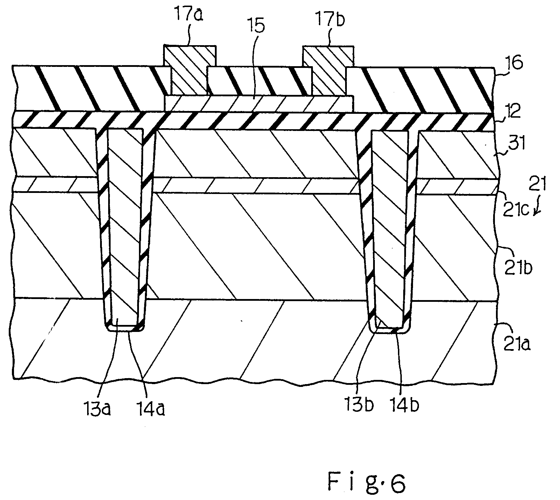

Turning to Fig. 6 of the drawings, the structure of yet another resistor embodying the present invention is formed on the silicon substrate 21 implemented by the lightly doped p-type silicon layer 21a, the heavily doped n-type buried layer 21b and the lightly doped n-type silicon layer 21c. The structure of the resistor implementing the third embodiment is similar to that of the second embodiment except for a p-type impurity region 31 formed in the surface portion of the lightly doped n-type silicon layer 21c, and films and electrodes are labeled with the same references designating the corresponding films and electrodes of the second embodiment. In this instance, the p-type impurity region 31 is doped at 1 to 5 x 10¹⁶ cm⁻³.

The p-type impurity region 31 effectively decreases the capacitance of the additional capacitor, and the actual capacitance coupled with the resistor is decreased to 40 % of the capacitance of the parasitic capacitor. This results in that the switching action is further accelerated.

### Fourth Embodiment

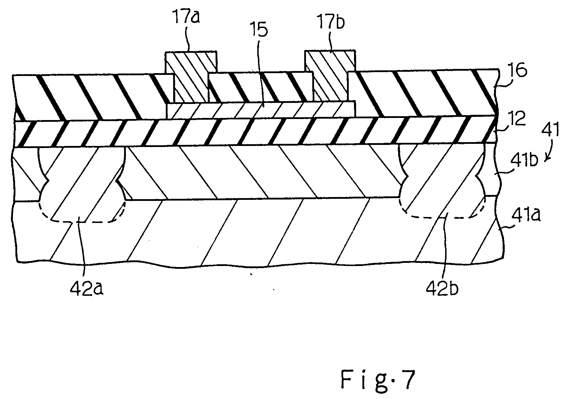

Turning to Fig. 7 of the drawings, still another resistor embodying the present invention is fabricated on a silicon substrate 41. The silicon substrate 41 comprises a lightly doped p-type silicon film 41a and a lightly doped n-type silicon film 41b, and p-type impurity regions 42a and 42b project from the top surface of the lightly doped n-type silicon film 41b into the lightly doped p-type silicon film 41a. The p-type impurity regions 42a and 42b are produced through a diffusion process or an ion-implantation process, and serve as an electrically isolating means. However, the other films and electrodes are similar to those of the first embodiment, and are, accordingly, labeled with the same references. The p-type impurity regions 42a and 42b are doped at 1 to 5 x 10¹⁸ cm⁻³.

The p-type impurity regions 42a and 42b allows the lightly doped n-type region of the silicon film 41b to enter electrically floating state, and the advantages of the first embodiment are achieved. The p-type impurity regions 42a and 42b are produced through the simple process rather than the process of forming the trench isolation.

As will be appreciated from the foregoing description, the electrically isolating means forms an additional capacitor coupled in series with the parasitic capacitor, and the actual parasitic capacitance coupled with the resistor is decreased for accelerating the signal propagation.

Although particular embodiments of the present invention have been shown and described, it will be obvious to those skilled in the art that various changes and modifications may be made without departing from the spirit and scope of the present invention. For example, the resistor according to the present invention is applicable to not only a Bi-CMOS circuit but also any semiconductor integrated circuit device.

## Claims

1. A semiconductor integrated circuit device comprising
a) a semiconductor substrate (11; 21; 41) having a first semiconductor layer (11a; 21a; 41a) of a first conductivity type (P), and a second semiconductor layer (11b; 21b/21c; 41b) grown on said first semiconductor layer and having a second conductivity type (N) opposite to said first conductivity type, said first and second semiconductor layers being reversely biased with each other,
b) an insulating film (12) formed over said second semiconductor layer, and
c) a plurality of circuit components (Q11 to Q14; NM; R11 to R14) having a resistor (15) formed on said insulating film,
characterized by
d) an electrically isolating means (13a/ 13b/ 14a/ 14b) projecting from said insulating film into said first semiconductor layer for allowing a part (11c) of said second semiconductor layer under said insulating film to enter electrically floating state.

2. A semiconductor integrated circuit device as set forth in claim 1, in which said resistor, said insulating film and said part of said second semiconductor layer form in combination a parasitic capacitor (Cox), and said part of said second semiconductor layer, an interface between said first and second semiconductor layers and said first semiconductor layer form in combination an additional capacitor (Cj) coupled in series with said parasitic capacitor.

3. A semiconductor integrated circuit device as set forth in claim 1, in which said electrically isolating means is implemented by a trench isolation (13a/ 13b/ 14a/ 14b) projecting from said insulating film into said first semiconductor layer.

4. A semiconductor integrated circuit device as set forth in claim 3, in which said second semiconductor layer (21a) comprises a heavily doped semiconductor film (21b) on said first semiconductor layer and a lightly doped semiconductor film (21c) on said heavily doped semiconductor film.

5. A semiconductor integrated circuit device as set forth in claim 4, in which further comprising e) a third semiconductor layer (31) of said first conductivity type inserted at least between said insulating film (12) and said part of said second semiconductor layer.

6. A semiconductor integrated circuit device as set forth in claim 1, in which said electrically isolating means is implemented by impurity regions (42a/ 42b) of said first conductivity type projecting from the lower surface of said insulating film into said first semiconductor layer.
